# EUROPEAN PATENT SPECIFICATION

(11) **EP 4 621 421 B1**
(45) Date of publication and mention of the grant of the patent: **16.09.2026**
(21) Application number: 25161741.1
(22) Date of filing: 05.03.2025
(51) Int. Cl.: G01R 29/26

(54) **A METHOD OF MEASURING PHASE NOISE AND A DEVICE FOR CARRYING OUT SAID METHOD**
VERFAHREN ZUR MESSUNG VON PHASENRAUSCHEN UND VORRICHTUNG ZUR DURCHFÜHRUNG DES VERFAHRENS
PROCEDE DE MESURE DU BRUIT DE PHASE ET DISPOSITIF DE MISE EN OEUVRE DE CE PROCEDE

(30) Priority: 18.03.2024 SI 202400040
(43) Date of publication of application: 24.09.2025
(73) Proprietor: Univerza v Ljubljani, 1000 Ljubljana (SI)
(72) Inventor: LAVRIC, Andrej, 1223 Blagovica (SI); BATAGELJ, Bostjan, 1000 Ljubljana (SI); Vidmar, Matjaz, 5000 Nova Gorica (SI)
(74) Representative: Ivancic, Bojan

(56) References cited:
- CN-A- 106 771 688
- CN-A- 115 714 620
- ADLES ERIC J ET AL: "Photonic phase noise characterization of W-band oscillators", 2013 IEEE PHOTONICS CONFERENCE, IEEE, 8 September 2013 (2013-09-08), pages 410 - 411, XP032523511, DOI: 10.1109/IPCON.2013.6656611
- JIANG ZHIDONG ET AL: "Wideband and High-Sensitivity Microwave Phase Noise Measurement Based on Photonic Time Delay and Frequency-Conversion Delay Matching", 2023 OPTO-ELECTRONICS AND COMMUNICATIONS CONFERENCE (OECC), IEEE, 2 July 2023 (2023-07-02), pages 1 - 4, XP034396888, DOI: 10.1109/OECC56963.2023.10209675

## Description

The present invention relates to a method of measuring a phase noise with a mixer or phase detector in a device for measuring the phase noise of a high-frequency signal by means of at least one optical delay branch.

The method of measuring the phase noise with a mixer or phase detector in a device for measuring the phase-noise of a high-frequency signal by means of an optical delay branch is disclosed in patent SI 26215. The said device comprises a first non-delayed signal branch, which is routed directly to the input of the microwave mixer, and a second non-delayed signal branch, which is routed to an optical delay unit. A shortcoming of the said method lies in the fact that the lower limit of applicability is in the range above 10 GHz.

In addition, a broadband microwave photon phase noise measuring device and method has been disclosed in a document CN 115714620. Disclosed solution enables the conversion of the measured signal to a lower frequency prior to the actual evaluation of phase noise. This effectively extends the usable range towards higher frequencies of the measured signal. The trade-off is a complex measuring instrument that requires manual adjustment by the operator.

The object of the present invention is to create a new method of measuring the phase noise with a mixer or phase detector in a device for measuring the phase noise of a high-frequency signal by means of at least one optical delay branch, which would remedy the shortcomings of the known solution.

The object according to the present invention is accomplished by the characteristics set forth in the characterising portion of claim 1. Details of the invention are disclosed in the corresponding sub-claims.

According to the invention, it is provided to set the phase in the optical branch by means of setting the wavelength of the laser, which, through the chromatic dispersion in at least one optical fibre, preferably in two optical fibres, causes the desired phase shift. The said desired phase shift is achieved by means of feedback from the mixing stage of a phase noise meter known *per se.* Both the method and the device according to the present invention are simple and are based on the active correction of the phase of a high-frequency signal by means of laser wavelength change.

The present invention exploits the already known fact that the wavelength of a laser can be varied by temperature, supply current, or the length of the external resonator. For practical use, the implementation of changing the wavelength by changing the laser temperature is preferably suitable, since the laser wavelength increases very linearly with increasing temperature.

By selecting the wavelength, it is possible to fine-tune the delay in the optical link without changing the length of the fibre. With a control circuit that adjusts the temperature of the laser module, it is possible to fine-tune the delay to satisfy the quadrature condition of the mixer. The advantage of the present method is in the low costs and simplicity of the control circuit, which intelligently controls the already expensive components of the system.

The desired phase shift is obtained via feedback from the mixing stage of the known phase noise meter. In this case, the wavelength or phase is set in such a way that there is no DC component at the mixer output.

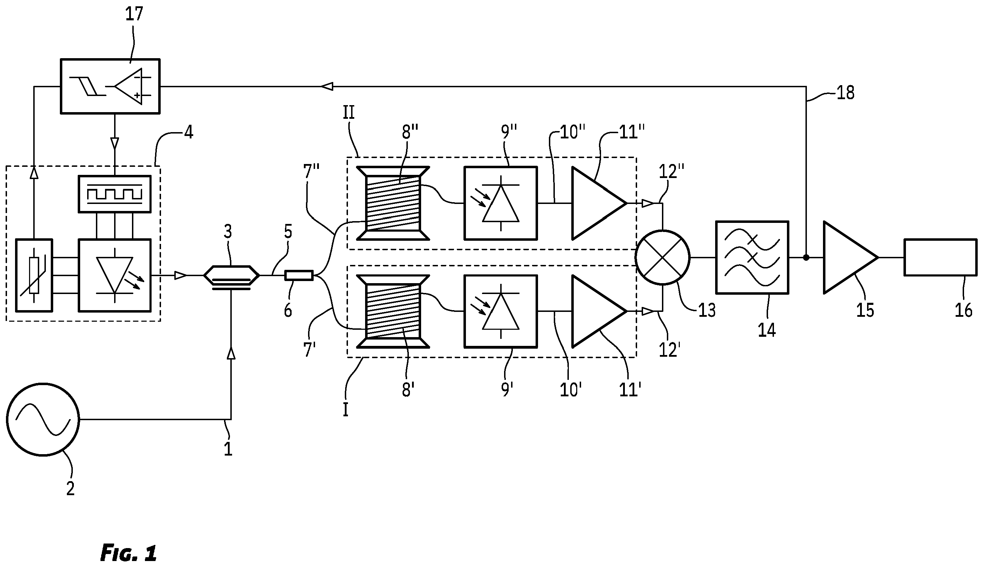

The invention is further described in detail by way of a non-limiting embodiment and with a reference to the attached drawing where Fig. 1 shows a diagram of the device for measuring the phase noise of a high-frequency signal.

Phase noise measurement according to the frequency discrimination method is a technique known *per se,* where the down-conversion is obtained with a phase detector on which the measured signal is compared to its own delayed copy. The use of a delayed copy for a shift to the baseband eliminates the requirement for a high-quality reference signal.

For the correct operation of the phase noise meter with at least one optical delay branch, it is necessary to ensure a 90° shift of all input signals between the inputs of the mixer. In these circumstances, the mixer is in quadrature and operates as a phase detector.

The reason for the phase shift between the two inputs is the difference in the length of the signal path on both branches. In a typical setting of a frequency discriminator for measuring phase noise, an adjustable phase shifter is provided to satisfy the quadrature condition of the non-delayed branch, by means of which the phase difference is set that is equal to ${ϕ}_{0} = 2 n ⋅ {180}^{0} + {90}^{0} ,$ wherein *n*=0,1,2,...

From the relationship *ϕ*=*ωτ* , it can be seen that the said quadrature is adjusted solely by means of the length of delay in one of the branches. When implementing a frequency discriminator with an optical fibre as a delay element, an additional problem arises with phase stabilisation due to changes in ambient temperature. The said problem is typically solved with temperature stabilisation of the optical fibre and laser source.

According to the present invention, instead of the stabilisation of individual subsystems, it is, in particular, preferably provided that the change of delay length is implemented by means of changing the laser wavelength, which presents a simple solution. Instead of the measurement system being isolated from environmental influences, which is a state of the art known *per se,* the present invention corrects or compensates for environmental influences in a simple manner.

The frequency dependence of the refraction index of the fibre means a different effective fibre length for different wavelengths of light, and thus consequently different delay lengths. The change in delay depends on the change in wavelength according to formula $Δ τ \left(λ,Δλ\right) = L {\int }_{λ - Δ λ}^{λ + Δ λ} D \left(λ\right) dλ ,$ where
- λ: represents the wavelength of the optical source, for example a laser bracket,
- L: represents the length of the optical fibre and
- D(λ): represents the chromatic dispersion of the optical fibre.

It turns out that to increase the range of delay change, it is necessary to increase either the length L of the optical fibre, chromatic dispersion D(λ) of the optical fibre, or the range of wavelength λ adjustments of the laser bracket. In practice, the length L of the optical fibre is limited to below 2000 m as it determines the bandwidth of the phase noise that can be measured. Chromatic dispersion D(λ) is a property of an optical fibre, which in the case of standard fibres takes known values. Increasing the adjustment range of the wavelengths λ of the optical source, for example a laser, can in practice be implemented by means of lasers with external resonators, which are adjusted mechanically. Such lasers are relatively large and expensive. Adjusting them requires a mechanical resonator adjustment, which makes it difficult to create feedback.

Taking into account the connection *ϕ*=*ωτ* and the assumption that an integral can be approximated with a straight line, a phase change is possible that is equal to $Δ ϕ \left(λ,Δλ\right) = ω ⋅ L ⋅ \left(aλ+b\right) ⋅ Δ λ ,$ where
a and b represent the chromatic dispersion approximation coefficients.

Referring to Fig. 1, which shows a device for measuring phase noise, the electrical signal 1 of the measured quantity 2 is routed directly to the electro-optical modulator 3 by means of which it is possible to modulate the optical source of the wavelength λ originating from the optical source 4. The said optical source 4 is known per se and preferably selected as a laser. Exiting the electro-optical modulator 3 is a modulated optical signal 5, which enters the optical splitter 6, where the said modulated optical signal 5 splits to a set of optical signals. In the specific embodiment, it is provided that the said modulated optical signal 5 in the optical splitter 6 splits into two optical signals 7'; 7", each of which is routed to a corresponding delay branch **I**; **II**.

It is provided for, according to the present invention, that the first delay branch **I** comprises the first optical fibre 8' with the length L' and a refraction index n', and that the second delay branch **II** comprises the second optical fibre 8" with the length L" and a refraction index n". The delayed optical signal exiting from each optical fibre 8'; 8" is routed to a corresponding photodiode 9'; 9", where the modulated optical signal 5 or each optical signal 7'; 7" from the optical domain is converted back to the electrical domain, i.e. to the electrical signal 10'; 10". The said electrical signals 10'; 10" are subsequently routed to the corresponding low-noise amplifier 11'; 11", after which the electrical signals 12'; 12" amplified in this manner are routed from each delay branch **I; II** to the mixer 13.

It is provided for, according to the present invention, that the lengths L'; L" of each optical fibre 8'; 8" are mutually different. Furthermore, it is provided for, according to the present invention, that the chromatic dispersions D'; D" of each optical fibre 8'; 8" are mutually different.

Each said optical signal 7'; 7" in each delay branch **I; II** thus gains a delay $τ = \frac{L ⋅ n}{{c}_{0}} ,$ where
- c₀: represents the speed of light in vacuum,
- L: represents the length of each optical fibre 8'; 8", and
- n: represents the refraction index of each optical fibre 8'; 8".

Since the optical fibres 8'; 8" in each delay branch **I; II** differ both in terms of length and in terms of chromatic dispersion, the difference ΔL in the length L'; L" of optical fibres 8'; 8" is applicable for a suitable delay τ for the operation of the device for measuring phase noise. The said delay τ is thus equal to $τ = \frac{L ′ ⋅ n ′ - L " ⋅ n "}{{c}_{0}} ,$ where
- c₀: represents the speed of light in vacuum,
- L: represents the length of each optical fibre 8'; 8", and
- n: represents the refraction index of each optical fibre 8'; 8".

The range of a full phase shift Δτ_{g} for phase adjustment depends on the change Δλ in the wavelength of the optical source 4 with a central wavelength λ and is equal to $Δ {τ}_{g} = \left(L′⋅D′-L"⋅D"\right) ⋅ Δ λ ,$ where
- L: represents the length of each optical fibre 8'; 8",
- D: represents the chromatic dispersion of each optical fibre 8'; 8", and
- Δλ: represents the change in the wavelength of the light exiting from the optical source 4.

The delayed electrical signals 12'; 12" exiting from the said delay branches **I; II** are routed to the corresponding high-frequency inputs of the microwave mixer 13. When there exists on the said inputs of the microwave mixer 13 a phase difference between the electrical signal 12' of the first delay branch I and the electrical signal 12" of the second delay branch **II** an odd multiple 90°, the microwave mixer 13 operates as a phase detector or in the so-called quadrature mode. From the microwave mixer 13, the electrical signal of the mixer, which is the product of the first delay branch **I** and the second delay branch **II,** is routed to a low-pass filter 14, which filters out undesired higher products of the microwave mixer 13. Furthermore, from the said low-pass filter 14, the filtered electrical signal is routed via the low-noise amplifier 15, where an adequately amplified electrical signal is routed to a FFT spectrum analyser 16 for observation.

When the microwave mixer 13 operates as a phase detector or in the quadrature mode, no DC component appears in the electrical signal on its output. For the microwave mixer 13 to operate in the desired mode, it is necessary to adjust the wavelength λ of the optical source 4 so that there is no DC component on the output of the microwave mixer 13. This is achieved by a feedback loop, which comprises a control circuit 17, where at the site between the low-pass filter 14 and low-noise amplifier 15, an electrical control signal 18 is split from the microwave mixer 13. The control circuit 17 calculates the error or deviation of the DC component of the said electrical signal of the mixer 13 from the limit value, for example from 0 V, and the signal of the error or the control signal 18 is adequately amplified and used to control, i.e. heat or cool the optical source 4, which consequently changes the wavelength A. The control circuit 17 controls the optical source 4, so that the DC component of the electrical signal of the mixer at the branch line to the control signal 18 is equal to the limit value, for example 0 V.

The difference ΔL between the lengths L'; L" of each optical fibre 8'; 8" preferably falls in the range between 100 m and 2000 m. By means of optical fibres 8'; 8" of lengths L'; L", which comprise a 10-km size class, the lower limit of the applicability of the measuring device for measuring the phase noise of signals extending into the MHz range.

## Claims

1. A method of measuring phase noise on a mixer or phase detector in a device for measuring the phase noise of a high-frequency signal by means of at least one optical delay line, wherein said method comprises the following steps:
a) routing of an electrical signal (1) of a measured quantity (2) directly to an electro-optical modulator (3), by means of which it is possible to modulate an optical signal of a wavelength (λ) originating from an optical source (4);
b) splitting, by means of an optical splitter (6), a modulated optical signal (5) exiting from the electro-optical modulator (3) into two optical signals (7'; 7"), each of which is routed to a corresponding delay branch (I; II), wherein a first delay branch (**I**) comprises a first optical fibre (8'), which comprises a length (L') with a chromatic dispersion (D') and a refraction index (n'), and that a second delay branch (**II**) comprises a second optical fibre (8"), which comprises a length (L") with a chromatic dispersion (D") and a refraction index (n"), said lengths (L'; L") of each optical fibre (8'; 8") being mutually different and said chromatic dispersions (D'; D") of each optical fibre (8'; 8") being mutually different;
c) routing the delayed optical signal exiting each optical fibre (8'; 8") of the respective delay branch (**I; II**) to a corresponding photodiode (9'; 9"), wherein the two optical signals (7'; 7") are converted from the optical domain back into electrical signals (10'; 10"), and subsequently routing the electrical signals (10'; 10") to the respective low-noise amplifier (11'; 11");
d) routing the delayed electrical signals (12'; 12") exiting the respective low-noise amplifier (11'; 11") of said delay branches (**I; II**) to the corresponding high-frequency inputs of a microwave mixer (13);
e) routing, from the microwave mixer, (13), the electrical signal from the mixer (13), which is the product of the first delay branch (I) and the second delay branch (**II**), to a low-pass filter (14), which filters out undesired higher products of the microwave mixer (13);
f) adjusting, by means of a feedback loop comprising a control circuit (17), the wavelength (λ) of the optical source (4) so that there is no DC component at the output of the microwave mixer (13);
g) routing the filtered electrical signal from the said low-pass filter (14) via a low-noise amplifier (15), where an adequately amplified electrical signal is routed to an FFT spectrum analyser (16) for observation.

2. A device for measuring the phase noise of a high-frequency signal by means of at least one optical delay unit, wherein said device comprises
a) electro-optical modulator (3) into which an electrical signal (1) of a measured quantity (2) is to be fed and to be converted in the electro-optical modulator (3) into an optical signal (5), said electro-optical modulator (3) being configured to modulate an optical signal of a wavelength (λ) originating from an optical source (4); and an optical splitter (6) into which the optical signal (5) is to be fed and split into two optical signals (7'; 7");
b) a first delay branch (**I**) and a second delay branch (**II**), wherein the optical signal (7') is directed to the first delay branch (**I**) and the optical signal (7") is directed to the second delay branch (**II**), wherein the first delay branch (**I**) comprises a first optical fibre (8'), which comprises a length (L') with a chromatic dispersion (D') and a refraction index (n'), and that the second delay branch (**II**) comprises a second optical fibre (8"), which comprises a length (L") with a chromatic dispersion (D") and a refraction index (n"), said lengths (L'; L") of each optical fibre (8'; 8") being mutually different and said chromatic dispersions (D'; D") of each optical fibre (8'; 8") being mutually different; two photodiodes, each of which configured to convert each of the optical signals exiting each optical fibre (8'; 8") of the respective delay branch (I; II), from the optical domain back into electrical signals (10'; 10"), and two low-noise amplifiers (11'; 11") each of which configured to receive each one of said electrical signals (10'; 10");
c) a microwave mixer (13), configured to receive at its high-frequency inputs, the two electrical signals (10'; 10");
a feedback loop comprising a control circuit (17) and configured to adjust the wavelength (λ) of the optical source (4) so that there is no DC component at the output of the microwave mixer (13);
d) a low-pass filter (14) configured to receive from the mixer (13) an electrical signal representing the product of the signals from the first delay branch (**I**) and the second delay branch (**II**);
e) a low-noise amplifier (15), configured to receive the filtered electrical signal from the low-pass filter (14); and
f) an FFT spectrum analyser (16) configured to analyse the amplified electrical signal received from the low-noise amplifier (15).

## Patentansprüche

1. Verfahren zur Messung des Phasenrauschens eines Mischers oder Phasendetektors in einer Vorrichtung zur Messung des Phasenrauschens eines Hochfrequenzsignals mittels mindestens einer optischen Verzögerungsleitung, wobei das Verfahren die folgenden Schritte umfasst:
a) Zuführen eines elektrischen Signals (1) einer Messgröße (2) direkt zu einem elektrooptischen Modulator (3), mittels dessen ein von einer optischen Quelle (4) stammendes optisches Signal einer Wellenlänge (λ) modulierbar ist;
b) Aufteilen eines den elektrooptischen Modulator (3) verlassenden modulierten optischen Signals (5) mittels eines optischen Splitters (6) in zwei optische Signale (7', 7"), von denen jedes einem entsprechenden Verzögerungszweig (I; II) zugeführt wird, wobei ein erster Verzögerungszweig (I) eine erste optische Faser (8') mit einer Länge (L'), einer chromatischen Dispersion (D') und einem Brechungsindex (n') umfasst und ein zweiter Verzögerungszweig (II) eine zweite optische Faser (8") mit einer Länge (L"), einer chromatischen Dispersion (D") und einem Brechungsindex (n") umfasst, wobei sich die Längen (L'; L") der optischen Fasern (8'; 8") voneinander unterscheiden und sich die chromatischen Dispersionen (D'; D") der optischen Fasern (8'; 8") voneinander unterscheiden;
c) Zuführen des aus jeder optischen Faser (8'; 8") des jeweiligen Verzögerungszweigs (I; II) austretenden verzögerten optischen Signals zu einer entsprechenden Photodiode (9'; 9"), wobei die beiden optischen Signale (7'; 7") aus dem optischen Bereich wieder in elektrische Signale (10'; 10") umgewandelt werden, und anschließendes Zuführen der elektrischen Signale (10'; 10") zu den jeweiligen rauscharmen Verstärkern (11'; 11");
d) Zuführen der aus den jeweiligen rauscharmen Verstärkern (11'; 11") der Verzögerungszweige (I; II) austretenden verzögerten elektrischen Signale (12'; 12") zu den entsprechenden Hochfrequenzeingängen eines Mikrowellenmischers (13);
e) Zuführen des elektrischen Signals aus dem Mikrowellenmischer (13), welches das Produkt der Signale des ersten Verzögerungszweigs (I) und des zweiten Verzögerungszweigs (II) darstellt, zu einem Tiefpassfilter (14), welches unerwünschte höherfrequente Mischprodukte des Mikrowellenmischers (13) herausfiltert;
f) Einstellen der Wellenlänge (λ) der optischen Quelle (4) mittels einer Rückkopplungsschleife, die eine Steuerschaltung (17) umfasst, derart, dass am Ausgang des Mikrowellenmischers (13) keine Gleichspannungskomponente vorhanden ist;
g) Zuführen des gefilterten elektrischen Signals von dem Tiefpassfilter (14) über einen rauscharmen Verstärker (15), wobei ein ausreichend verstärktes elektrisches Signal einem FFT-Spektrumanalysator (16) zur Beobachtung zugeführt wird.

2. Vorrichtung zur Messung des Phasenrauschens eines Hochfrequenzsignals mittels mindestens einer optischen Verzögerungseinheit, wobei die Vorrichtung umfasst:
a) einen elektrooptischen Modulator (3), dem ein elektrisches Signal (1) einer Messgröße (2) zuführbar ist und in dem das elektrische Signal in ein optisches Signal (5) umwandelbar ist, wobei der elektrooptische Modulator (3) dazu eingerichtet ist, ein von einer optischen Quelle (4) stammendes optisches Signal einer Wellenlänge (λ) zu modulieren, sowie einen optischen Splitter (6), dem das optische Signal (5) zuführbar ist und der dazu eingerichtet ist, das optische Signal (5) in zwei optische Signale (7'; 7") aufzuteilen;
b) einen ersten Verzögerungszweig (I) und einen zweiten Verzögerungszweig (II), wobei das optische Signal (7') dem ersten Verzögerungszweig (I) und das optische Signal (7") dem zweiten Verzögerungszweig (II) zuführbar ist, wobei der erste Verzögerungszweig (I) eine erste optische Faser (8') mit einer Länge (L'), einer chromatischen Dispersion (D') und einem Brechungsindex (n') umfasst und der zweite Verzögerungszweig (II) eine zweite optische Faser (8") mit einer Länge (L"), einer chromatischen Dispersion (D") und einem Brechungsindex (n") umfasst, wobei sich die Längen (L'; L") der optischen Fasern (8'; 8") voneinander unterscheiden und sich die chromatischen Dispersionen (D'; D") der optischen Fasern (8'; 8") voneinander unterscheiden; zwei Photodioden (9'; 9"), von denen jede dazu eingerichtet ist, das aus der jeweiligen optischen Faser (8'; 8") des entsprechenden Verzögerungszweigs (I; II) austretende optische Signal aus dem optischen Bereich wieder in ein elektrisches Signal (10'; 10") umzuwandeln, sowie zwei rauscharme Verstärker (11'; 11"), von denen jeder dazu eingerichtet ist, jeweils eines der elektrischen Signale (10'; 10") zu empfangen;
c) einen Mikrowellenmischer (13), der dazu eingerichtet ist, an seinen Hochfrequenzeingängen die beiden elektrischen Signale (10'; 10") zu empfangen; eine Rückkopplungsschleife mit einer Steuerschaltung (17), die dazu eingerichtet ist, die Wellenlänge (λ) der optischen Quelle (4) derart einzustellen, dass am Ausgang des Mikrowellenmischers (13) keine Gleichspannungskomponente vorhanden ist;
d) ein Tiefpassfilter (14), das dazu eingerichtet ist, von dem Mikrowellenmischer (13) ein elektrisches Signal zu empfangen, das das Produkt der Signale des ersten Verzögerungszweigs (I) und des zweiten Verzögerungszweigs (II) repräsentiert;
e) einen rauscharmen Verstärker (15), der dazu eingerichtet ist, das von dem Tiefpassfilter (14) gefilterte elektrische Signal zu empfangen; und
f) einen FFT-Spektrumanalysator (16), der dazu eingerichtet ist, das von dem rauscharmen Verstärker (15) empfangene verstärkte elektrische Signal zu analysieren.

## Revendications

1. Procédé de mesure du bruit de phase d'un mélangeur ou d'un détecteur de phase dans un dispositif de mesure du bruit de phase d'un signal haute fréquence au moyen d'au moins une ligne à retard optique, ledit procédé comprenant les étapes consistant à:
a) acheminer un signal électrique (1) d'une grandeur mesurée (2) directement vers un modulateur électro-optique (3), au moyen duquel un signal optique de longueur d'onde (λ) provenant d'une source optique (4) peut être modulé;
b) diviser, au moyen d'un séparateur optique (6), un signal optique modulé (5) sortant du modulateur électro-optique (3) en deux signaux optiques (7', 7"), chacun étant acheminé vers une branche de retard correspondante (I ; II), une première branche de retard (I) comprenant une première fibre optique (8') présentant une longueur (L'), une dispersion chromatique (D') et un indice de réfraction (n'), et une deuxième branche de retard (II) comprenant une deuxième fibre optique (8") présentant une longueur (L"), une dispersion chromatique (D") et un indice de réfraction (n"), les longueurs (L' ; L") des fibres optiques (8' ; 8") étant différentes l'une de l'autre et les dispersions chromatiques (D' ; D") des fibres optiques (8' ; 8") étant différentes l'une de l'autre;
c) acheminer le signal optique retardé sortant de chaque fibre optique (8' ; 8") de la branche de retard correspondante (I ; II) vers une photodiode correspondante (9' ; 9"), les deux signaux optiques (7' ; 7") étant reconvertis du domaine optique en signaux électriques (10' ; 10"), puis acheminer les signaux électriques (10' ; 10") vers les amplificateurs à faible bruit correspondants (11' ; 11");
d) acheminer les signaux électriques retardés (12' ; 12") sortant des amplificateurs à faible bruit correspondants (11' ; 11") desdites branches de retard (I ; II) vers les entrées haute fréquence correspondantes d'un mélangeur hyperfréquence (13);
e) acheminer, depuis le mélangeur hyperfréquence (13), le signal électrique provenant du mélangeur (13), représentant le produit des signaux issus de la première branche de retard (I) et de la deuxième branche de retard (II), vers un filtre passe-bas (14), qui élimine les produits de mélange d'ordre supérieur indésirables du mélangeur hyperfréquence (13);
f) régler, au moyen d'une boucle de rétroaction comprenant un circuit de commande (17), la longueur d'onde (λ) de la source optique (4) de telle sorte qu'aucune composante continue ne soit présente à la sortie du mélangeur hyperfréquence (13);
g) acheminer le signal électrique filtré provenant dudit filtre passe-bas (14) via un amplificateur à faible bruit (15), un signal électrique suffisamment amplifié étant acheminé vers un analyseur de spectre FFT (16) pour observation.

2. Dispositif de mesure du bruit de phase d'un signal haute fréquence au moyen d'au moins une unité de retard optique, ledit dispositif comprenant :
a) un modulateur électro-optique (3), auquel un signal électrique (1) d'une grandeur mesurée (2) est destiné à être appliqué et dans lequel il est destiné à être converti en un signal optique (5), ledit modulateur électro-optique (3) étant configuré pour moduler un signal optique de longueur d'onde (λ) provenant d'une source optique (4), ainsi qu'un séparateur optique (6), auquel le signal optique (5) est destiné à être appliqué et qui est configuré pour diviser ledit signal optique (5) en deux signaux optiques (7' ; 7");
b) une première branche de retard (I) et une deuxième branche de retard (II), le signal optique (7') étant dirigé vers la première branche de retard (I) et le signal optique (7") étant dirigé vers la deuxième branche de retard (II), la première branche de retard (I) comprenant une première fibre optique (8') présentant une longueur (L'), une dispersion chromatique (D') et un indice de réfraction (n'), et la deuxième branche de retard (II) comprenant une deuxième fibre optique (8") présentant une longueur (L"), une dispersion chromatique (D") et un indice de réfraction (n"), les longueurs (L' ; L") des fibres optiques (8' ; 8") étant différentes l'une de l'autre et les dispersions chromatiques (D' ; D") des fibres optiques (8' ; 8") étant différentes l'une de l'autre; deux photodiodes (9' ; 9"), chacune étant configurée pour reconvertir le signal optique sortant de la fibre optique correspondante (8' ; 8") de la branche de retard correspondante (I ; II) du domaine optique en un signal électrique (10' ; 10"), et deux amplificateurs à faible bruit (11' ; 11"), chacun étant configuré pour recevoir l'un desdits signaux électriques (10' ; 10");
c) un mélangeur hyperfréquence (13), configuré pour recevoir, à ses entrées haute fréquence, les deux signaux électriques (10' ; 10"); une boucle de rétroaction comprenant un circuit de commande (17) et configurée pour régler la longueur d'onde (λ) de la source optique (4) de telle sorte qu'aucune composante continue ne soit présente à la sortie du mélangeur hyperfréquence (13);
d) un filtre passe-bas (14), configuré pour recevoir du mélangeur (13) un signal électrique représentant le produit des signaux issus de la première branche de retard (I) et de la deuxième branche de retard (II);
e) un amplificateur à faible bruit (15), configuré pour recevoir le signal électrique filtré provenant du filtre passe-bas (14); et
f) un analyseur de spectre FFT (16), configuré pour analyser le signal électrique amplifié reçu de l'amplificateur à faible bruit (15).
